# EUROPEAN PATENT APPLICATION

(11) **EP 2 523 346 A1**
(43) Date of publication of application: **14.11.2012**
(21) Application number: 11360017.5
(22) Date of filing: 09.05.2011
(51) Int. Cl.: H03F 3/72

(54) **Amplifier comprising switchable amplifier stages and method thereof**

(71) Applicant: Alcatel Lucent, 75007 Paris (FR)
(72) Inventor: Wong James N H, London W3 OHW (GB)
(74) Representative: Leppard, Andrew John

(57) **Abstract**

An amplifier (340A) comprises a plurality of amplifier stages (380,390) having their outputs connected to the amplifier output (RF OUT). An amplifier input signal (RF IN) is applied via a switching mechanism (370) to the inputs of the plurality of amplifier stages (380,390). The amplifier comprises furthermore a bias controller (350) that is adapted to selectively adjust biasing parameters of each of the amplifier stages, for instance, their supply voltage. Moreover, the amplifier comprises a power controller that, in response to a desired amplifier output level, configures both the switching mechanism and the bias controller.

## Description

### FIELD OF THE INVENTION

The present invention relates to an amplifier and a method.

### BACKGROUND

Amplifiers are known. In most communications systems it is required that amplifiers, such as power amplifiers, used to amplify signals for wireless telecommunication transmissions are able to operate with high efficiency. In addition, many wireless telecommunications systems, such as a global system for mobile communications (GSM)/enhanced data rates for GSM evolution (EDGE), code division multiple access (CDMA) or wideband code division multiple access (WCDMA), require that the power amplifiers are able to deliver a wide range of output powers.

Accordingly, power amplifiers are typically designed to provide the highest power output level with maximum available efficiency. These power amplifiers, which may be provided in base stations, tend to operate less efficiently at lower power levels. Designing a base station power amplifier which has high efficiency not only at the maximum power but also at lower output levels, typically ranging from -6dB and less, is challenging. Although different amplifier arrangements exist, they each have their own shortcomings.

Accordingly, it is desired to provide an improved amplifier.

### SUMMARY

According to a first aspect, there is provided an amplifier operable to receive an input signal at an amplifier input and to provide an amplified output signal at an amplifier output, the amplifier comprising: a plurality of amplifier stages, each amplifier stage having an amplifier stage input operable to receive a signal to be amplified and to provide an amplified signal at an amplifier stage output coupled with the amplifier output; a switching mechanism operable to selectively couple each of the amplifier stage inputs with the amplifier input to receive the input signal; a biasing controller operable to selectively adjust biasing parameters of each of the amplifier stages; and a power controller operable, in response to a request to provide the amplified output signal with a requested power output, to configure the switching mechanism and the biasing controller to couple at least one of the plurality of amplifier stages biased with adjusted biasing parameters to provide the amplified output signal with the requested power output.

The first aspect recognises that a problem with many existing amplifiers is that those amplifiers lack efficiency over a wide range of output powers. In particular, the first aspect recognises that such amplifiers may be utilised in remote radio head products and that the transmission power of output signals transmitted by those remote radio head products may vary dramatically at different times of the day. For example, it may be desirable to be able to reduce the transmission power of the remote radio head product to less than one third of its nominal maximum transmission power. Reducing the transmission power in this way may be desirable when user traffic levels are low, such as, for example, during the night. Such variation in power output required by the amplifier presents difficulties when trying to operate the amplifier with high efficiency.

Accordingly, an amplifier which receives an input signal at an input and which generates an amplified output signal at an amplifier output is provided. A plurality of amplifier stages may be provided, each of which has an amplifier stage input which receives a signal to be amplified and which generates an amplified signal at an amplifier stage output. The amplifier stage output of each amplifier stage may then be coupled with the amplifier output to generate the resultant amplified output signal. A switching mechanism may be provided which selectively couples the amplifier stage inputs with the amplifier input to enable the input signal to be provided to each coupled amplifier stage. A biasing controller may be provided which may selectively adjust biasing parameters of each of the amplifier stages. A power controller may be provided which configures the switching mechanism and the biasing controller in response to a requested power output. This configuring may couple a number of amplifier stages, each biased with adjusted biasing parameters to receive the input signal and to generate the amplified output signal with the requested power output.

Through this approach it is possible to select the required combination of amplifiers or amplifier stages to receive the input signal and to change the biasing parameters of the selected amplifier stages to improve their efficiency. This approach ensures that only the required amplifier stages are utilised and that the amplifier stages utilised achieve optimal efficiency. Those amplifier stages not utilised may remain unpowered. This helps to provide an arrangement which can provide a greater range of output powers with higher efficiency.

In one embodiment, each amplifier stage comprises an amplifier coupled at the amplifier stage output with an associated transmission line coupled with the amplifier output, the associated transmission line having an effective electrical length which presents an open circuit to other amplifier stages coupled with the amplifier output when the amplifier is biased to be non-amplifying. Hence, an output network of transmission lines may be provided coupled with the amplifier stage outputs. The effective electrical length of those transmission lines may then be selected to present an open circuit to other amplifier stages when an amplifier stage is non-amplifying. It will be appreciated that such an approach helps to further improve efficiency by reducing losses caused by power flowing into amplifier stage outputs of amplifiers which are not powered and therefore not providing amplified signals.

In one embodiment, the switching mechanism is operable to selectively couple each of the amplifier stage inputs in parallel with the amplifier input to receive the input signal. Accordingly, each of the amplifier stages may amplify the input signal in parallel and provide their amplified signals in parallel to be combined to provide the amplified output signal.

In one embodiment, the plurality of amplifier stages comprises a pair of amplifier stages and the switching mechanism is operable to selectively couple one of the pair of amplifier stages in parallel with another of the pair of amplifier stages coupled with the amplifier input. Accordingly, a pair of amplifier stages may be provided. One of the pair may be permanently coupled with the amplifier input, with the other of the pair being selectively switchable in parallel to the amplifier input. It will be appreciated that this provides a simple mechanism for adding additional amplifier stages when required.

In one embodiment, the biasing parameters comprise one of a drain voltage and a collector voltage. Accordingly, the drain voltage or collector voltage of the amplifier stage may be varied in response to the requested power output. It will be appreciated that varying the voltage supplied to the amplifier stage will change its efficiency characteristics for different power outputs. By adjusting these supply voltages it is possible therefore to operate the amplifier with increased efficiency for the requested power output.

In one embodiment, the power controller is operable to configure the biasing controller to adjust the drain voltage of each amplifier stage to provide the amplified output signal with the requested power output. Accordingly, the drain voltage of each of the amplifier stages may be changed such that those amplifier stages may together provide the amplified output signal with the requested power.

In one embodiment, the power controller is operable to reconfigure the switching mechanism to provide the input signal to a combination of the amplifier stages to provide the amplified output signal with the requested power output. Accordingly, only the required amplifier stages needed to provide the amplified output signal with the requested power output may receive the input signal.

In one embodiment, the power controller is operable to reconfigure the switching mechanism and the biasing controller to select a combination of amplifier stages biased with an adjusted drain voltage which maximises amplifier efficiency at the requested power output. Accordingly, a number of amplifier stages, each biased with adjusted biasing parameters, may be configured to receive the input signal in order to provide the amplified output signal with optimum amplifier efficiency.

In one embodiment, the power controller comprises a lookup table providing, for each of a plurality of requested power outputs, switching mechanism configuration information for reconfiguring the switching mechanism and biasing controller configuration information for configuring the biasing controller. Accordingly, a look-up table may be provided which is used to control the switching mechanism and the biasing controller in response to the requested power output. It will be appreciated that this provides a simple and convenient mechanism for dynamic control of the amplifier with minimum processing power.

In one embodiment, the power controller is operable to determine an actual power output of the amplified output signal and to adjust the biasing parameters in dependence on a variance between the actual power output and the requested power output. Accordingly, a feedback loop may be provided which varies the biasing parameters based on any difference between the requested power output and a measured power output.

In one embodiment, the power controller is operable to update the lookup table with revised biasing controller configuration information based on the adjusted biasing parameters. Accordingly, the biasing parameters may be updated in the look-up table based on feedback provided as a result of measuring the actual output power.

In one embodiment, each amplifier stage comprises an identical amplifying device.

According to a second aspect, there is provided a method of configuring an amplifier operable to receive an input signal at an amplifier input and provide an amplified output signal at an amplifier output, the method comprising the steps of: providing a plurality of amplifier stages, each amplifier stage having an amplifier stage input operable to receive a signal to be amplified and provide an amplified signal at an amplifier stage output coupled with the amplifier output; selectively coupling each of the amplifier stage inputs with the amplifier input to receive the input signal; selectively adjusting biasing parameters of each of the amplifier stages; and in response to a request to provide the amplified output signal with a requested power output, coupling at least one of the plurality of amplifier stages biased with adjusted biasing parameters to provide the amplified output signal with the requested power output.

In one embodiment, each amplifier stage comprises an amplifier coupled at the amplifier stage output with an associated transmission line coupled with the amplifier output, the associated transmission line having an effective electrical length which presents an open circuit to other amplifier stages coupled with the amplifier output when the amplifier is biased to be non-amplifying.

In one embodiment, the method comprises the step of: selectively coupling each of the amplifier stage inputs in parallel with the amplifier input to receive the input signal.

In one embodiment, the plurality of amplifier stages comprises a pair of amplifier stages and the method comprises the step of: selectively coupling one of the pair of amplifier stages in parallel with another of the pair of amplifier stages coupled with the amplifier input.

In one embodiment, the biasing parameters comprise one of a drain voltage and a collector voltage.

In one embodiment, the method comprises the step of: adjusting the drain voltage of each amplifier stage to provide the amplified output signal with the requested power output.

In one embodiment, the method comprises the step of: providing the input signal to a combination of the amplifier stages to provide the amplified output signal with the requested power output.

In one embodiment, the method comprises the step of: selecting a combination of amplifier stages biased with an adjusted drain voltage which maximises amplifier efficiency at the requested power output.

In one embodiment, the method comprises the step of: a combination of amplifier stages biased with an adjusted drain voltage determined with reference to a lookup table.

In one embodiment, the method comprises the steps of: determining an actual power output of the amplified output signal and adjusting the biasing parameters in dependence on a variance between the actual power output and the requested power output.

In one embodiment, the method comprises the step of: updating the lookup table with revised biasing controller configuration information based on the adjusted biasing parameters.

In one embodiment, each amplifier stage comprises an identical amplifying device.

Further particular and preferred aspects are set out in the accompanying independent and dependent claims. Features of the dependent claims may be combined with features of the independent claims as appropriate, and in combinations other than those explicitly set out in the claims.

### BRIEF DESCRIPTION OF THE DRAWINGS

Embodiments of the present invention will now be described further, with reference to the accompanying drawings, in which:
Figure 1 illustrates an arrangement of a power amplifier pallet according to one embodiment;
Figure 2 is a graph illustrating the relationship between gain and supply voltage for a typical amplifier;
Figure 3 is a graph illustrating the relationship between output power of a typical amplifier and efficiency when biasing the amplifier with different supply voltages;
Figure 4 is a schematic diagram illustrating an adaptive tri-sector remote radio head according to one embodiment; and
Figure 5 illustrates example components of an amplifier arrangement according to one embodiment.

### Overview

Before discussing embodiments in any detail, an overview will now be provided. Amplifier stages, such as power amplifiers, may be deployed in many situations. For example, amplifiers are typically provided within existing remote radio head products provided in, for example, base stations of a wireless telecommunications network. Those remote radio head products currently typically offer a minimum of a single transmitter per sector. However, many base stations support three or more sectors. This would require network operators to purchase a minimum of three remote radio heads per base station. Also, the number of remote radio heads per base station increases with different frequency bands and standards being supported by that base station (for example, GSM, WCDMA, UMTS, LTE, etc.). Each power amplifier consumes energy and the proliferation of such amplifiers increases the amount of energy consumed. In addition, many existing remote radio head products provide optimum efficiency performance at maximum transmission power (i.e., when there is a full traffic load). Furthermore, the transmit power of each sector is typically different at different times of the day.

This proliferation of inefficiency results in unnecessarily high energy consumption to the network operator. Any inefficiency in a power amplifier is duplicated as the number of power amplifiers increases. Accordingly, embodiments utilise a switching matrix concept which is typically applied at the input of a final stage power amplifier.

This switching of the final stage power amplifier enables a reduced number of power amplifiers to be utilised in some circumstances in order to reduce energy consumption. Furthermore, the biasing of the power amplifier through changes in the supply voltage to the power amplifiers varies the output power of those power amplifiers being utilised, as will be described in more detail below.

### Power Amplifier Pallet

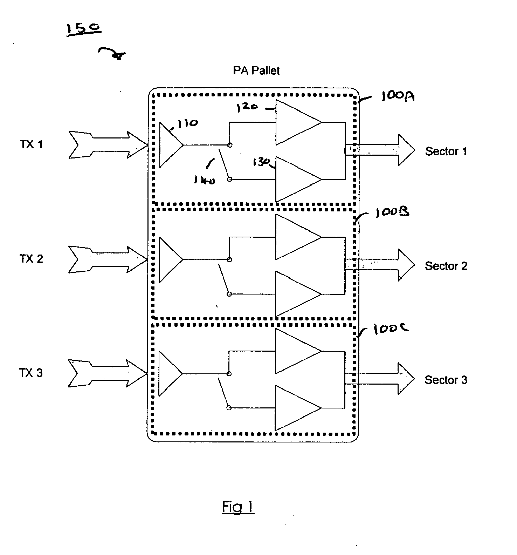

Figure 1 illustrates an arrangement of a power amplifier pallet for use in a remote radio head according to one embodiment. In this embodiment, the remote radio head supports three sectors and so three amplifier arrangements 100A-100C are provided, each of which receives an associated signal TX1 - TX3 to be amplified for transmission within the associated sector.

The signal is received at an input amplifier 110 which conditions the signal prior to subsequent amplification. The input amplifier 110 is coupled via a switch 140 with a pair of power amplifiers 120, 130 or amplifier stages. In one configuration of the switch 140, the input amplifier 110 is coupled with the power amplifier 120. In another configuration of the switch 140, the input amplifier 110 is coupled with both the power amplifier 120 and the power amplifier 130.

Accordingly, dependent on the configuration of the switch 140, the input signal may be amplified by either the power amplifier 120 on its own or by both the power amplifier 120 and the power amplifier 130. The output of the power amplifiers 120, 130 are combined and provided for transmission to the associated sector. As can be seen, this arrangement is duplicated for each sector. It will be appreciated that differing number of sectors than three may be supported, as well as different frequency bands and different standards.

With this arrangement, full transmission power on any of these sectors is enabled when the switch 140 is turned on to enable the input signal to be amplified by both the power amplifier 120 and the power amplifier 130. Reduced transmission power on any of these sectors in enabled when the power amplifiers are biased with a reduced supply voltage and/or the switch 140 is turned off to enable the input signal to be amplified by only the power amplifier 120.

Such a combining method using parallel amplifier stages enables smaller power transistors to be used and, hence, can be operated more effectively and efficiently. The relationship between output radio frequency (RF) power and supply voltage to the transistors is utilised as a form of power control. For example, a nominal operating voltage for laterally diffused metal oxide semiconductor (LDMOS) transistors is 28 volts.

If each power amplifier 120, 130 delivers 20 watts at 28 volts, then by increasing the supply voltage to 31 volts it is possible to achieve 30 watts from each power amplifier 120, 130, giving a maximum transmission power of 60 watts when the switch 140 is turned on. If, however, only 10 watts is required, then the switch 140 may be turned off which decouples the path to the power amplifier 130 and the supply voltage to the power amplifier 120 is turned down to 18 volts.

Such switching, coupled with variable supply voltages, offers a solution for adaptive transmission power.

### Amplifier Characteristic Curves

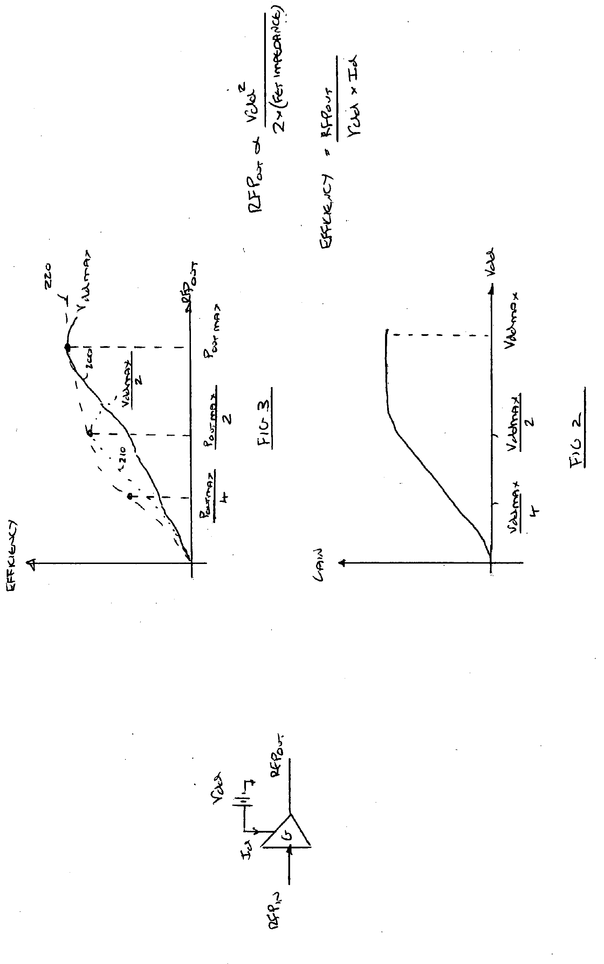

Figure 2 is a graph illustrating the relationship between gain and supply voltage for a typical amplifier or amplifier stage. As can be seen, the gain reduces as the supply voltage reduces.

Figure 3 is a graph illustrating the relationship between output power of a typical amplifier or amplifier stage and efficiency when biasing the amplifier with different supply voltages. For example, the curve 200 shows the relationship between output power and efficiency when providing a maximum supply voltage Vddmax to the amplifier. As can be seen, the efficiency is greatest when the output power is at its maximum Poutmax. However, the efficiency is significantly reduced when the output power is halved Poutmax/2.

Curve 210 shows the relationship between efficiency and output power when the same amplifier is biased with half of the maximum supply voltage Vddmax/2. As can be seen, the efficiency is greatest when the output power is at half of its maximum Poutmax/2. It follows, therefore, that when the output power is at half of its maximum Poutmax/2, the efficiency from the amplifier is greater when biased with half of the maximum supply voltage Vddmax/2 than when biased with the maximum supply voltage Vddmax.

The curve 220 shows an envelope of maximum possible efficiencies for different supply voltages. As can be seen, the maximum possible efficiency typically reduces as the output power reduces for any particular amplifier. However, the efficiency at lower powers can be increased by using smaller power amplifiers. With the arrangement disclosed herein, such smaller amplifiers may be switched together and their outputs combined to provide a greater power output with greater efficiency.

### Adaptive Tri-Sector Remote Radio Head

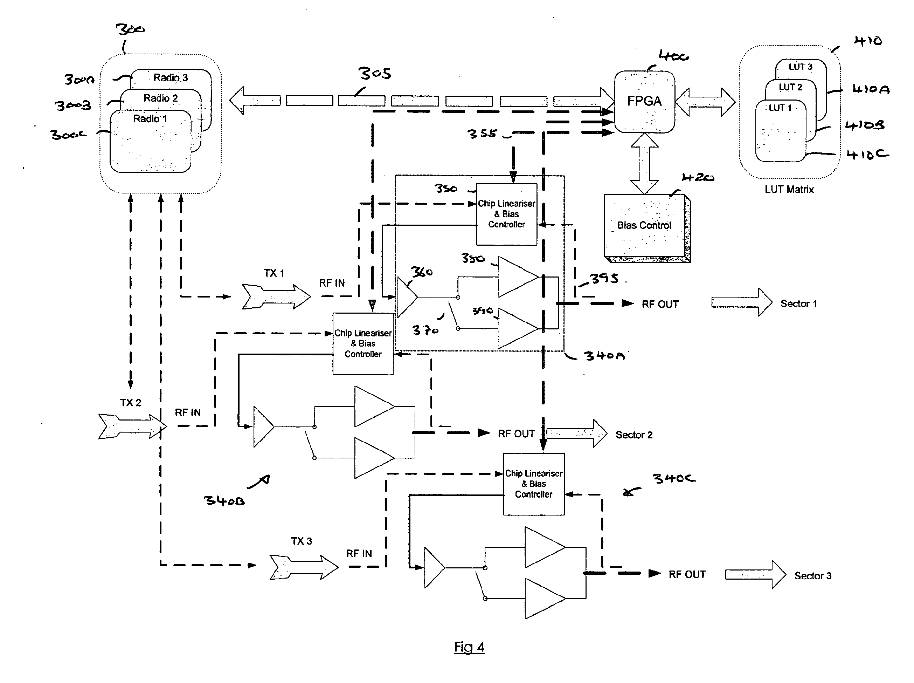

Figure 4 is a schematic diagram illustrating an adaptive tri-sector remote radio head according to one embodiment. In this arrangement, a radio device 300 comprises three radio sub-systems 300A - 300C, each of which provide an RF signal TX1-TX3 to be amplified. Each RF signal TX1 - TX3 to be amplified is provided to an associated power amplifier arrangement 340A-340C.

Taking the example of the RF signal TX 1 provided by the radio sub-system 300C, this is provided to a chip linearization and bias controller 350. The chip linearizer and bias controller 350 conditions the RF signal TX1 to account for changes caused by subsequent amplification and propagation prior to being provided to the input amplifier 360.

The output from the input amplifier 360 is provided via a switch 370 to a pair of power amplifiers 380, 390 or amplifier stages, dependent on the state of the switch 370. A required output transmission power indicated to the radio system 300C for that RF signal (such as, for example, 10 watts) is provided either over a communications channel 305 to a field-programmable gate array (FPGA) 400 or other programmable processing device, or is determined by the chip linearizer and bias controller 350 from the RF signal TX1 itself and provided over a path 355 to the FPGA 400.

The FPGA 400 determines the required transmission power to be provided by the associated amplifier arrangement by referring to an associated look-up table 410A-410C provided by a look-up table matrix 410. Each look-up table 410A-410C provides switching information and biasing information for each amplifier arrangement when providing different output transmission powers.

For example, taking the example described above with reference to Figure 1, should the output transmission power be required to be 10 watts, then the look-up table 410A will provide information to the FPGA 400 which instructs the chip linearizer and bias controller 350 to configure the switch 370 to decouple the amplifier 390 from the input amplifier 360 and to supply a supply voltage of 18 volts to the power amplifier 380.

Likewise, if an output transmission power of 60 watts is required, then the look-up table 410A will provide information to the FPGA 400 which causes the chip linearizer and bias controller 350 to configure the switch 370 such that both the power amplifier 380 and the power amplifier 390 are coupled with the input amplifier 360 and the voltage supplied to the power amplifier 380 and 390 is set to 31 volts.

It will be appreciated that each chip linearizer and bias controller receives bias voltages provided by the bias control 420 also under the control of the FPGA 400 also based on configuration information provided by the associated lookup table.

Accordingly, it can be seen that each RF signal to be amplified to be transmitted to each of the three sectors may have its transmission power independently controlled through the configuration of the associated switching element and the biasing of the power amplifiers or amplifier stages.

Each look-up table 410A - 410C may be configured to provide such configuration information for any of a range of different output transmission powers expected to be provided by the associated amplifier arrangement 340A - 340C.

The appropriate configuration information stored in each look-up table 410A - 410C will typically be pre-programmed prior to installation of the tri-sector remote radio head in the field, based on bench testing or modelling which determines an appropriate configuration to maximise efficiency at each of a number of different output transmission powers. It will be appreciated that the exact biasing will vary from amplifier to amplifier and may require a different number of amplifiers provided in parallel, as well as biasing those amplifiers with different supply voltages.

To improve the accuracy of the control of output transmission power, the actual output transmission power may be sensed using a power detector and details of this provided to the chip linearizer and bias controller 350 over the path 395. This feedback path may be used to adjust the biasing and/or switching configuration of the switch 370 in order to provide the required output transmission power. For example, the biasing may be increased or decreased by predetermined steps in response to this feedback. Deviation from the expected transmission power output may occur for any number of reasons, such as changes in the configuration of the remote radio head, its antenna array, aging of the components or other environmental factors. The FPGA 400 may also use the information provided via the feedback path 395 to update the look-up tables within the look-up table matrix 410 to account for such variation.

### Amplifier Arrangement

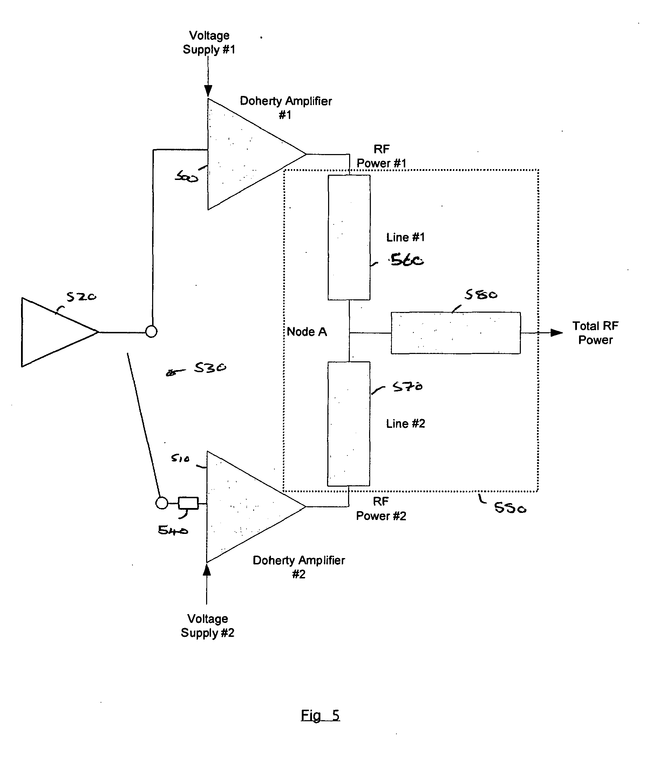

Figure 5 illustrates example components of an amplifier arrangement according to one embodiment. In this example, two Doherty amplifiers 500, 510 or amplifier stages are provided which are coupled with an input amplifier 520 via a switch 530. The signal to be amplified is provided from the input amplifier 520 via the switch 530. Control of the switch 530 and the supply voltage to the amplifiers 500, 510 may occur in a similar manner to that described above. One of the Doherty amplifiers may be provided with a phase corrector 540, if required.

The amplified signal provided by each of the amplifiers 500, 510 is provided to a combining network 550 of microstrip lines 560, 570, 580. The effective electrical length of the microstrip lines 560, 570 is equal and set such that, should either the amplifier 500 or the amplifier 510 be switched off, an RF open circuit is presented at node A to the remaining amplifying amplifier.

It will be appreciated that this arrangement may be utilised in the embodiments described above and assists in further enhancing the efficiency by avoiding any stray power being fed back into the non-amplifying amplifier. For example, should the amplifier 510 be non-amplifying, then an effective infinite impedance is presented at node A to the output of the amplifier 500 which reduces losses in the output transmission power provided by that amplifier.

Accordingly, it can be seen that a single remote radio head solution offering multi sector support is provided. Such an arrangement allows adaptive transmission power on each of the sectors by a combination of a switching matrix and a variable supply voltage. This arrangement provides for efficiency which is optimally maintained across all power levels.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. An amplifier operable to receive an input signal at an amplifier input and to provide an amplified output signal at an amplifier output, said amplifier comprising:
a plurality of amplifier stages, each amplifier stage having an amplifier stage input operable to receive a signal to be amplified and to provide an amplified signal at an amplifier stage output coupled with said amplifier output;
a switching mechanism operable to selectively couple each of said amplifier stage inputs with said amplifier input to receive said input signal;
a biasing controller operable to selectively adjust biasing parameters of each of said amplifier stages; and
a power controller operable, in response to a request to provide said amplified output signal with a requested power output, to configure said switching mechanism and said biasing controller to couple at least one of said plurality of amplifier stages biased with adjusted biasing parameters to provide said amplified output signal with said requested power output.

2. The amplifier as claimed in claim 1, wherein each amplifier stage comprises an amplifier coupled at said amplifier stage output with an associated transmission line coupled with said amplifier output, said associated transmission line having an effective electrical length which presents an open circuit to other amplifier stages coupled with said amplifier output when said amplifier is biased to be non-amplifying.

3. The amplifier as claimed in claim 1 or 2, wherein said switching mechanism is operable to selectively couple each of said amplifier stage inputs in parallel with said amplifier input to receive said input signal.

4. The amplifier as claimed in any preceding claim, wherein said plurality of amplifier stages comprises a pair of amplifier stages and said switching mechanism is operable to selectively couple one of said pair of amplifier stages in parallel with another of said pair of amplifier stages coupled with said amplifier input.

5. The amplifier as claimed in any preceding claim, wherein said biasing parameters comprise one of a drain voltage and a collector voltage.

6. The amplifier as claimed in any preceding claim, wherein said power controller is operable to configure said biasing controller to adjust said drain voltage of each amplifier stage to provide said amplified output signal with said requested power output.

7. The amplifier as claimed in any preceding claim, wherein said power controller is operable to reconfigure said switching mechanism to provide said input signal to a combination of said amplifier stages to provide said amplified output signal with said requested power output.

8. The amplifier as claimed in any preceding claim, wherein said power controller is operable to reconfigure said switching mechanism and said biasing controller to select a combination of amplifier stages biased with an adjusted drain voltage which maximises amplifier efficiency at said requested power output.

9. The amplifier as claimed in any preceding claim, wherein said power controller comprises a lookup table providing, for each of a plurality of requested power outputs, switching mechanism configuration information for reconfiguring said switching mechanism and biasing controller configuration information for configuring said biasing controller.

10. The amplifier as claimed in any preceding claim, wherein said power controller is operable to determine an actual power output of said amplified output signal and to adjust said biasing parameters in dependence on a variance between said actual power output and said requested power output.

11. The amplifier as claimed in claim 10, wherein said power controller is operable to update said lookup table with revised biasing controller configuration information based on said adjusted biasing parameters.

12. The amplifier as claimed in any preceding claim, wherein each amplifier stage comprises an identical amplifying device.

13. A method of configuring an amplifier operable to receive an input signal at an amplifier input and to provide an amplified output signal at an amplifier output, said method comprising the steps of:
providing a plurality of amplifier stages, each amplifier stage having an amplifier stage input operable to receive a signal to be amplified and provide an amplified signal at an amplifier stage output coupled with said amplifier output;
selectively coupling each of said amplifier stage inputs with said amplifier input to receive said input signal;
selectively adjusting biasing parameters of each of said amplifier stages; and
in response to a request to provide said amplified output signal with a requested power output, coupling at least one of said plurality of amplifier stages biased with adjusted biasing parameters to provide said amplified output signal with said requested power output.
